**Europäisches Patentamt**

**European Patent Office**

**Office européen des brevets**

(11) Veröffentlichungsnummer : **0 365 622 B1**

(12) **EUROPÄISCHE PATENTSCHRIFT**

(45) Veröffentlichungstag der Patentschrift :
03.02.93 Patentblatt 93/05

(51) Int. Cl.⁵ : **G01N 27/72**

(21) Anmeldenummer : **89903691.7**

(22) Anmeldetag : **17.03.89**

(86) Internationale Anmeldenummer :
**PCT/DE89/00172**

(87) Internationale Veröffentlichungsnummer :
**WO 89/10557 02.11.89 Gazette 89/26**

(54) **VERFAHREN ZUM ZERSTÖRUNGSFREIEN MESSEN MAGNETISCHER EIGENSCHAFTEN EINES PRÜFKÖRPERS SOWIE VORRICHTUNG ZUM ZERSTÖRUNGSFREIEN MESSEN MAGNETISCHER EIGENSCHAFTEN EINES PRÜFKÖRPERS.**

(30) Priorität : **23.04.88 DE 3813739**

(43) Veröffentlichungstag der Anmeldung :
**02.05.90 Patentblatt 90/18**

(45) Bekanntmachung des Hinweises auf die
Patenterteilung :
**03.02.93 Patentblatt 93/05**

(84) Benannte Vertragsstaaten :
**AT BE CH FR GB IT LI LU NL SE**

(56) Entgegenhaltungen :
**WO-A-87/00293**
**FR-A- 2 312 777**
**US-A- 3 636 437**
**INDUSTRIAL LABORATORY, Band 43, Nr. 2, Februar 1977, Plenum Publishing Corp. (New York, US); M.A.KARAMYSHEV et al.: "Hardnessinspection of 38khA-Steel parts by the electromagnetic method with higher harmonics", Seiten 264-266**

(73) Patentinhaber :
**FRAUNHOFER-GESELLSCHAFT ZUR FÖRDERUNG DER ANGEWANDTEN FORSCHUNG E.V.**
**Leonrodstrasse 54**
**W-8000 München 19 (DE)**

(72) Erfinder : **DOBMANN, Gerd**
**Scheidterstrasse 23a**
**W-6602 Dudweiler (DE)**
Erfinder : **PITSCH, Holger**
**Heidenkopferdell 30**
**W-6600 Saarbrücken 3 (DE)**

(74) Vertreter : **Rackette, Karl, Dipl.-Phys. Dr.-Ing**
**Kaiser-Joseph-Strasse 179 Postfach 1310**
**W-7800 Freiburg (DE)**

## Beschreibung

Die Erfindung betrifft ein Verfahren zum zerstörungsfreien Messen magnetischer Eigenschaften eines Prüfkörpers, der in Aufsetztechnik in einem Magnetfeld einer mit einem Wechselstrom gespeisten Erregerspule magnetisiert wird, indem die Hysteresekurve des Prüfkörpers mit der Frequenz des Wechselstroms mehrfach durchgesteuert wird und die durch die Erregerspule erzeugte Tangentialfeldstärke auf der Prüfkörperoberfläche mit Hilfe eines Magnetfeldstärkesensors während der Durchsteuerung der Hysteresekurve laufend erfaßt wird, wobei während der Durchsteuerung der Hysteresekurve ein Signal abgeleitet wird, dessen zeitlicher Verlauf dem zeitlichen Verlauf der Tangentialfeldstärke zugeordnet ist, sowie eine Vorrichtung zur Durchführung des Verfahrens.

Eine derartiges Verfahren sowie eine entsprechende Vorrichtung sind aus der DE-A1-30 37 932 bekannt, wobei zusätzlich zu dem Magnetfeldstärkesensor zwischen den Magnetpolen ein zweiter Aufnehmer zum Erfassen des Barkhausenrauschens oder der Überlagerungspermeabilität des Prüfkörpers während des Durchsteuerns der Hysteresekurve vorgesehen ist. Während die mit einem induktiven Aufnehmer ausgerüstete bekannte Vorrichtung die Koerzitivfeldstärke des untersuchten Werkstoffes durch Auswerten des Rauschmaximums und Bestimmen der dem Rauschmaximum zugeordneten Tangentialfeldstärke ermittelt, ermittelt die mit einer Wirbelstromspule ausgerüstete Vorrichtung die Koerzitivfeldstärke dadurch, daß die von der Überlagerungspermeabilität des untersuchten Werkstoffes abhängige Impedanz der Wirbelstromspule gemessen wird und die der maximalen Impedanz zugeordnete Tangentialfeldstärke zur Bestimmung der Koerzitivfeldstärke herangezogen wird.

Sowohl die mit dem induktiven Aufnehmer zur Erfassung des Barkhausenrauschens ausgerüstete Vorrichtung als auch die mit der Wirbelstromspule versehene Vorrichtung benötigen zusätzlich zum Magnetfeldstärkesensor einen Sensor für eine zweite physikalische Größe. Außerdem ergeben sich durch den Einsatz des induktiven Aufnehmers für die Erfassung des Barkhausenrauschens sowie der Wirbelstromspule zur Erfassung der Überlagerungspermeabilität Einschränkungen bezüglich der erfaßbaren Meßtiefe, was insbesondere dann von Nachteil ist, wenn die Einhärtetiefe bestimmt werden soll, bzw. zur Werkstoffsortierung große Werkstoffvolumina erfaßt werden müssen.

Ausgehend von dem oben genannten Stand der Technik liegt der Erfindung die Aufgabe zugrunde, ein Verfahren und eine Vorrichtung zu schaffen, die es gestatten, magnetische Eigenschaften, insbesondere Koerzitivfeldstärken , sowie den Verlauf der Hysteresekurve am Koerzitivfeldstärkepunkt ohne zusätzlichen Sensor zum Magnetfeldstärkesensor auch bei großen Meßtiefen zu erfassen.

Diese Aufgabe wird erfindungsgemäß bei einem Verfahren der eingangs genannten Art dadurch gelöst, daß das abgeleitete Signal aus dem zeitlichen Verlauf des Tangentialfeldstärkesignals bestimmt wird, indem aus dem periodischen Gesamtsignal der Tangentialfeldstärke der Anteil des Oberwellensignals vom Gesamtwellensignal separiert wird, wobei die Separierung des Gesamtsignals durch eine Fourieranalyse einer Periode des Gesamtsignals erfolgt, mit deren Hilfe die komplexen Amplitudenkoeffizienten $A_i$ des Grundwellensignals und des Oberwellensignals bis mindestens zur Oberwelle 7. Ordnung bestimmt werden, daß als Maß für die Koerzitivfeldstärke des Prüfkörpers die augenblickliche Amplitude des Gesamtsignals der Tangentialfeldstärke zu einem Zeitpunkt ausgewählt wird, zu dem das mittels Fouriersynthese aus den obigen Amplitudenkoeffizienten $A_i$ ermittelte Oberwellensignal der Tangentialfeldstärke nach einem Nulldurchgang des Gesamtsignals der Tangentialfeldstärke den ersten Nulldurchgang hat, und daß die Amplituden der im Gesamtsignal enthaltenen Oberwellen ins Verhältnis zur Amplitude der Grundwelle oder Gesamtwelle gemäß

$$K = \sqrt{\frac{|A3|^2 + |A5|^2 + |A7|^2 + \ldots}{|A1|^2}}$$

gesetzt wird, wobei der auf diese Weise ermittelte Klirrfaktor K ein Maß für die Steigung der Hysteresekurve bei der Koerzitivfeldstärke ist.

Bei einer Vorrichtung zum zerstörungsfreien Messen magnetischer Eigenschaften eines Prüfkörpers mit einem auf den zu untersuchenden Prüfkörper mit seinen beiden Magnetpolen aufsetzbaren Aufsetzjoch, dessen Erregerspule zum Durchsteuern der Hysteresekurve des Prüfkörpers mit einer bipolaren Leistungsendstufe verbunden ist und zwischen dessen Magnetpolen ein Magnetfeldstärkesensor zur Erfassung der Tangentialfeldstärke angeordnet ist, der an einen Schaltkreis angeschlossen ist, welcher die durch Auswerten des zeitlichen Verlaufs der Tangentialfeldstärke bestimmten magnetischen Größen ausgibt, ist gemäß der Erfindung vorgesehen, daß der Magnetfeldstärkesensor an einen Fourieranalyse-Prozessor und an einen Fouriersynthese-Prozessor angeschlossen ist, durch die der zeitliche Verlauf des periodischen Sensorsignals in seinen Grundwellenanteil und seinen Oberwellenanteil separierbar ist, wobei mit Hilfe des Fourieranalyse-Prozessors das Sensorsignal bis mindestens zur Oberwelle 7. Ordnung in seine harmonischen Anteile zerlegbar ist und wobei mit Hilfe des Fouriersynthese-Prozessors die durch den Fourieranalyse-Prozessor separierten Oberwellenanteile zu einem von der Grundwelle befreiten Oberwellenanteil kombinierbar sind, und daß der Oberwellenanteil zusammen mit dem Gesamtsignal des Sensors und/oder dem Grundwellenanteil eine Auswerteprozessoreinheit speist, die einen Abtastprozessor für den zeitlichen Verlauf des Gesamtsignals der Tangentialfeldstärke und des Oberwellenanteils der Tangentialfeldstärke umfaßt, durch den ein Selektionssignal für die Tangentialfeldstärke erzeugbar ist, wenn dem gerade abgetasteten Gesamtsignal der Tangentialfeldstärke zeitlich ein Nulldurchgang des Oberwellenanteils zugeordnet ist, der als erster Nulldurchgang des Oberwellenanteils auf einen Nulldurchgang des Gesamtsignals folgt, daß der Auswerteprozessor einen Klirrfaktorprozessor umfaßt, durch den aus den Amplituden der Oberwellen $A_i$ und der Amplitude der Grundwelle $A_1$ der Klirrfaktor

$$K = \sqrt{\frac{|A3|^2 + |A5|^2 + |A7|^2 + \ldots}{|A1|^2}}$$

der Übertragungsstrecke zwischen der Erregerspule und dem Magnetfeldstärkesensor als Maß für die Steigung der Hysteresekurve bei der Koerzitivfeldstärke bestimmbar ist, wobei der Klirrfaktorprozessor an den Ausgang des Fourieranalyse-Prozessors angeschlossen ist.

Dadurch, daß zur Bestimmung der magnetischen Kenngrößen von Koerzitivfeldstärke und dem Verlauf der Hysteresekurve im Koerzitivfeldstärkepunkt nur das Tangentialfeldstärkesignal ausgewertet wird, verringert sich der gerätetechnische Aufwand um einen Meßkanal, ohne daß auf die Vorteile bekannter Verfahren und Vorrichtungen verzichtet zu werden braucht. Der Erfindung liegt die Erkenntnis zugrunde, daß die alleinige Messung der Tangentialfeldstärke die Ableitung einer Meßgröße erlaubt, die linear mit der Koerzitivfeldstärke korreliert. Darüber hinaus gestattet die Auswertung des Verlaufs der Tangentialfeldstärke die Bestimmung einer zweiten Meßgröße, die in linearer Korrelation zur maximalen Steigung der Hysteresekurve steht.

Zweckmäßige Ausgestaltungen und Weiterbildungen der Erfindung sind in den Unteransprüchen gekennzeichnet.

Nachfolgend wird ein Ausführungsbeispiel der Erfindung anhand der Zeichnung näher erläutert. Es zeigen:

Fig. 1 ein Blockschaltbild einer Vorrichtung gemäß der Erfindung,

Fig. 2 den Auswerteprozessor der erfindungsgemäßen Vorrichtung in einem Blockschaltbild und

Fig. 3 den zeitlichen Verlauf der von dem Magnetfeldstärkesensor erfaßten Tangentialfeldstärke in Bezug auf den zeitlichen Verlauf des darin enthaltenen Oberwellenanteils zur Veranschaulichung der der Erfindung zugrunde liegenden Erkenntnis für die Bestimmung der Koerzitivfeldstärke.

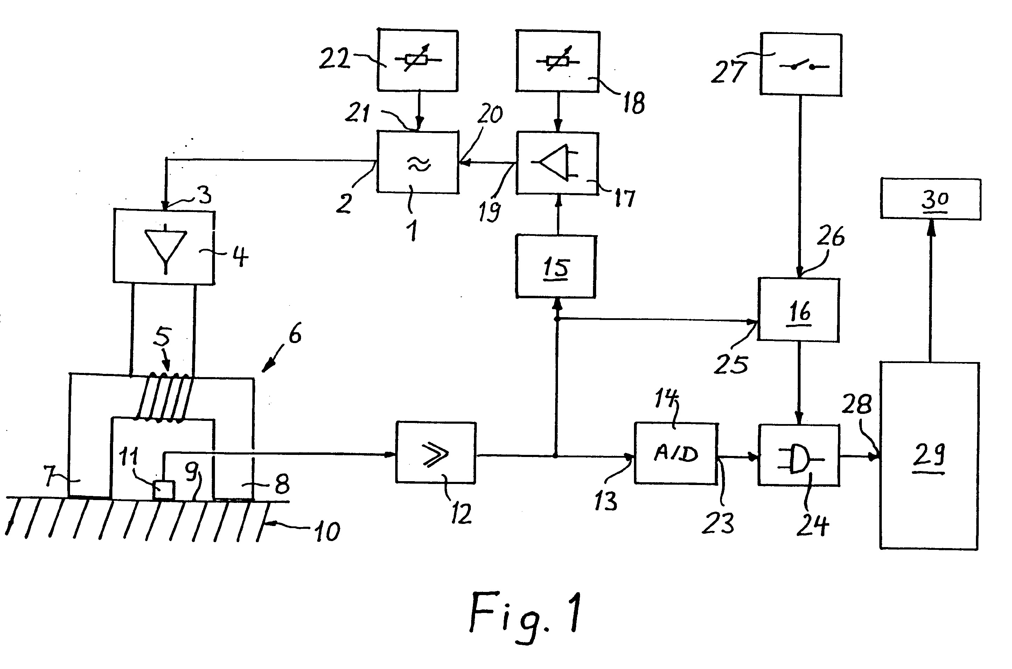

In Fig. 1 ist ein Ausführungsbeispiel für die Vorrichtung zur zerstörungsfreien Messung der Koerzitivfeldstärke sowie der maximalen Steigung der BH-Kurve oder Hysteresekurve dargestellt. Die Vorrichtung verfügt über einen Oszillator 1, dessen Frequenz zwischen 0 Hz und einigen kHz, insbesondere zwischen 10 Hz und 100 Hz durchstimmbar ist. Insbesondere kann der Oszillator 1, dessen Frequenz und dessen Amplitude einstellbar sind, ein Sinussignal mit 50 Hz erzeugen. Statt der Erzeugung eines Sinussignals ist es aber auch möglich, einen Oszillator 1 vorzusehen, der ein periodisches Zeitsignal einer anderen Form erzeugt. Die jeweils zwischen 0 Hz und einigen kHz eingestellte Magnetisierungsfrequenz bestimmt die Meßtiefe infolge des dem Fachmann bekannten Skin-Effektes.

Der Ausgang 2 des Oszillators 1 ist mit dem Steuereingang 3 eines bipolaren Netzgerätes oder einer bipolaren Leistungsendstufe 4 verbunden. Der Ausgang der Leistungsendstufe 4 speist eine Erregerspule 5, die auf ein Aufsetzjoch 6 aufgewickelt ist, das beispielsweise aus einer Vielzahl aufeinandergestapelter Elektrobleche besteht. Das Aufsetzjoch 6 verfügt über zwei Jochschenkel 7, 8, die zum Messen auf die Oberfläche 9 eines Prüfkörpers 10 aufsetzbar sind. Um Unebenheiten und unterschiedliche magnetische Widerstände, die sich hierdurch ergeben, auszugleichen, ist es vorgesehen, die Amplitude des Oszillators 1 entsprechend zu verändern, um zu erreichen, daß das vom Aufsetzjoch 6 im Prüfkörper 10 erzeugte periodische Wechselfeld in seinem Magnetfeldhub konstant bleibt.

Zwischen den Jochschenkeln 7, 8 ist symmetrisch zu diesen ein Magnetfeldstärkesensor, insbesondere eine Hallsonde 11, vorgesehen, die ebenfalls auf der Oberfläche 9 aufliegt und dazu dient, die Tangentialfeldstärke an der Oberseite 9 des Prüfkörpers 10 zu erfassen.

Die Gesamtinduktivität des Aufsetzjoches ist nicht nur von den Eigenschaften der Erregerspule 5 und dem Kernmaterial des Aufsetzjoches 6, sondern auch von den magnetischen Eigenschaften des Prüflings 10 abhängig.

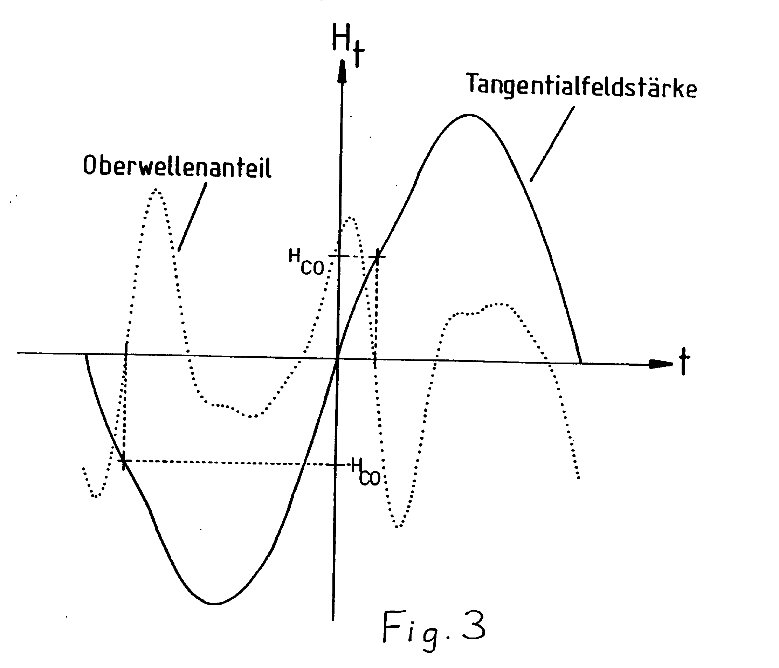

Bekanntlich ist bei ferromagnetischen Werkstoffen die Permeabilität magnetfeldabhängig. Dies führt zu einem Hystereseeinfluß und bei einer sinusförmigen Erregerspannung an der Erregerspule 5 zu einem nichtsinusförmigen zeitlichen Verlauf der Feldstärke im Prüfkörper 10. Der Hystereseeinfluß bedingt, daß neben der Grundfrequenz auch die ungeradzahligen höheren Harmonischen oder Oberwellen des Oszillatorsignals angeregt werden. Infolge des Hystereseeinflusses ergibt sich somit eine nichtlineare Frequenzcharakteristik und damit nichtlineare Verzerrungen. Die geradzahligen Oberwellen fehlen, weil die Hysteresekurve einen symmetrischen Verlauf hat. Die Hallsonde 11 gestattet es nunmehr, bei einer Anregung mit einem Oszillator 1, dessen Ausgangsspannung sinusförmig verläuft, den vom Sinusverlauf abweichenden Verlauf der Tangentialfeldstärke zu erfassen. In Fig. 3 ist der nichtsinusförmige Verlauf der Tangentialfeldstärke für eine Periode dargestellt.

Die Hallsonde 11 erzeugt ein periodisches Signal, das bei der Verwendung eines Oszillators 1 mit einer Sinusspannung die Gestalt eines verzerrten Sinus hat. Das Ausgangssignal der Hallsonde 11 wird mit Hilfe eines Verstärkers 12 verstärkt. Der Ausgang des Verstärkers 12 ist einerseits mit dem Eingang 13 eines Analog/Digital-Umsetzers 14 und andererseits mit einem Peak-Detektor oder Maximalamplituden-Detektor 15 verbunden. Außerdem speist das vom Verstärker 12 gelieferte Signal eine Triggerschaltung 16.

Durch den Maximalamplituden-Detektor 15 wird erfaßt, ob das dem Analog/Digital-Umsetzer 14 zugeführte Signal ausreichend groß ist. Ist dies nicht der Fall, wird die Amplitude des Oszillators 1 nachgeregelt und erhöht, was insbesondere dann der Fall sein kann, wenn aufgrund von Rauhigkeiten zwischen den Jochschenkeln 7, 8 und der Oberfläche 9 ein Luftspalt zu einer schlechteren Ankopplung und einem höheren magnetischen Widerstand führt. Der zum Stabilisieren der Maximalamplitude vorgesehene Regelkreis enthält neben dem Verstärker 12 und dem Maximalamplituden-Detektor 15 noch eine Komparatorschaltung 17, die mit dem Ausgang des Maximalamplituden-Detektors 15 verbunden ist. Die Komparatorschaltung 17 ist weiterhin mit einer Magnetfeldhubeinstellvorrichtung 18 verbunden, durch die die maximale H-Feldaussteuerung einstellbar ist. Der Ausgang 19 der Komparatorschaltung 15 speist den Amplitudeneingang 20 des Oszillators 1 zur Lieferung eines Korrektursignals für die Oszillatoramplitude. Der Oszillator 1 verfügt weiterhin über einen Frequenzeingang 21, der mit einer Frequenzeinstelleinrichtung 22 zur Einstellung und zur Veränderung der Magnetisierungsfrequenz verbunden ist. Der oben beschriebene Regelkreis gestattet es, die Hysteresekurve des Prüfkörpers 10 periodisch und mit einer stabilisierten Amplitude der Feldstärke durchzusteuern.

Beim Durchsteuern der Hysteresekurve des Prüfkörpers 10 liefert der Ausgang 21 des Analog/Digital-Umsetzers 14 ein digitalisiertes Tangentialfeldstärkesignal. Mit Hilfe einer Torschaltung 24 wird aus dem kontinuierlichen Tangentialfeldstärkesignal eine Periode herausgeschnitten. In Fig. 3 ist eine solche Periode der Tangentialfeldstärke dargestellt, die zum Beispiel durch 1024 Abtastpunkte erfaßt sein kann. Die Torschaltung 24 wird mit Hilfe der Triggerschaltung 16 kurz vor oder ab einem Nulldurchgang für genau eine Periode des Tangentialfeldstärkesignals geöffnet. Die dafür erforderliche Länge des Zeitfensters der Torschaltung 24 kann durch eine Schwellentriggerung oder durch Auswerten der Erregerfrequenz bestimmt werden. Bei dem in Fig. 1 dargestellten Schaltbild dient das am Eingang 25 der Triggerschaltung 16 anliegende verstärkte Tangentialfeldstärkesignal dazu, die Öffnungszeit der Torschaltung 24 erregerfrequenzabhängig einzustellen. Selbstverständlich ist es auch möglich, den Eingang 25 hierzu direkt mit dem Ausgang 2 des Oszillators 1 zu verbinden. Jedesmal, wenn eine Periode der Tangentialfeldstärke erfaßt werden soll, wird der Steuereingang 26 der Triggerschaltung 16 mit einem Startsignal beaufschlagt. Das Startsignal kann beispielsweise durch eine Starttaste 27 bei einer Einzelmessung oder durch einen kontinuierlich auftretenden Prüftakt erzeugt werden, wenn statt einer manuellen Meßauslösung eine automatische Meßauslösung erwünscht ist.

Aus der obigen Beschreibung ergibt sich, daß nach einer einzelnen Meßauslösung über die Torschaltung 24 eine Periode des digitalisierten Tangentialfeldstärkesignals zum Dateneingang 28 eines Auswerteprozessors 29 gelangt, der die Aufgaben der Steuerung der Vorrichtung, der Signalaufnahme und der Signalverarbeitung erledigt.

Der Auswerteprozessor 29 ermittelt aus der Gestalt der in Fig. 3 dargestellten Kurve der Tangentialfeldstärke während einer Periode die Koerzitivfeldstärke für den Prüfkörper 10 sowie die maximale Steigung der Hysteresekurve und zeigt diese Werte auf einer Anzeigeeinheit 30 an oder gibt diese Werte über eine Schnittstelle zur Steuerung von in Fig. 1 nicht dargestellten Einrichtungen weiter.

Der Auswerteprozessor 29 ermittelt für das durch die Magnetisierungsfrequenz festgelegte Meßvolumen im Prüfkörper 10 die Koerzitivfeldstärke und die maximale Steigung der Hysteresekurve durch eine Analyse der Abweichung des Tangentialfeldstärkesignals von der Signalform am Ausgang 2 des Oszillators 1, wobei bei dem hier beschriebenen Ausführungsbeispiel davon ausgegangen wird, daß der Oszillator 1 ein Sinusoszillator ist.

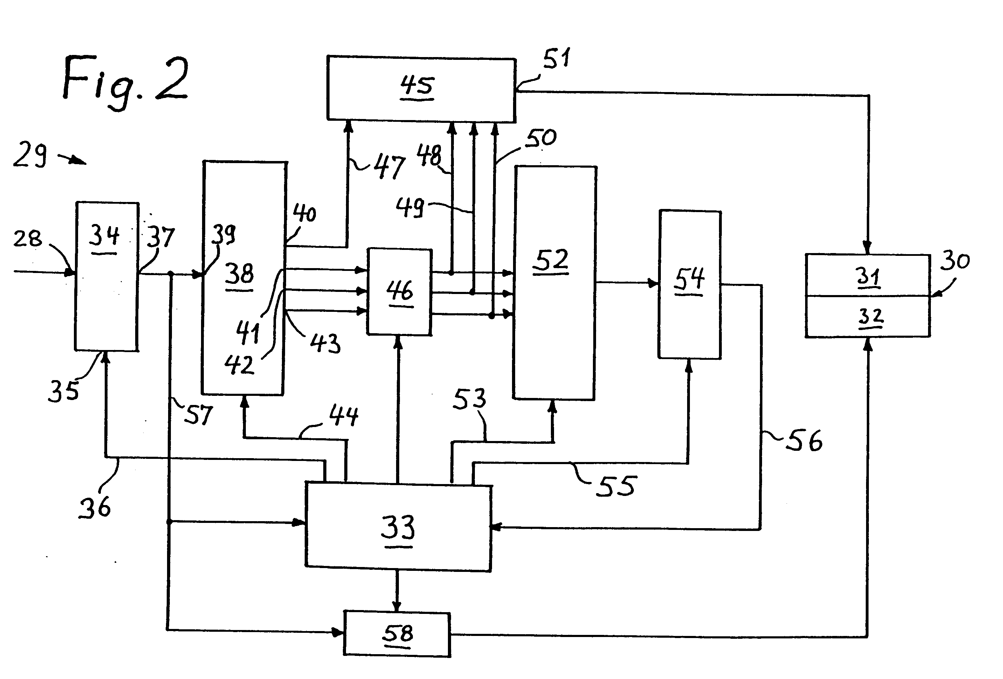

Fig. 2 zeigt ein Ausführungsbeispiel für den Auswerteprozessor 29 zusammen mit der Anzeigeeinheit 30, die ein Anzeigenfeld 31 für die maximale Steigung der Hysteresekurve und ein Anzeigefeld 32 für die Koerzitivfeldstärke aufweist.

Der Auswerteprozessor 29 verfügt über einen Steuer- und Abtastprozessor 33, der einerseits die verschiedenen Funktionsblöcke des Auswerteprozessors 29 steuert und andererseits zur Abtastung der in Fig. 3 dargestellten Kurve der Tangentialfeldstärke und des Oberwellenanteils dient.

Der Dateneingang 28 ist mit einem Tangentialfeldstärkespeicher 34 verbunden, der dazu dient, eine Periode des digitalisierten Tangentialfeldstärkesignals zu speichern. Der Tangentialfeldstärkespeicher 34 verfügt über einen Adreß- und Steuereingang 35, der über eine Adressen- und Steuerleitung 36 mit dem Steuer- und Abtastprozessor 33 verbunden ist.

Der Ausgang 37 des Tangentialfeldstärkespeichers 34 speist den Eingang 39 eines Fourieranalyse-Prozessors 38, der eine Fourierhintransformation des Tangentialfeldstärkesignals oder Gesamtsignals vornimmt. Das von der Hallsonde 11 gemessene Gesamtsignal der Tangentialfelstärke wird durch den Fourieranalyse-Prozessor 38 in seine harmonischen Anteile zerlegt, wobei am Ausgang 40 der komplexe Fourierkoeffizient A1 der Grundwelle und an den Ausgängen 41, 42 und 43 die komplexen Fourierkoeffizienten A3, A5 und A7 der jeweiligen höheren Harmonischen oder Oberwellen abgreifbar sind. Der Fourieranalyse-Prozessor 38 zerlegt somit das Gesamtsignal in eine Grundwelle und drei Oberwellen, wobei infolge der Symmetrie der Hysteresekurve nur Oberwellen ungerader Ordnung vorkommen und durch Auswerten von lediglich drei Oberwellen bereits eine ausreichend hohe Genauigkeit der Messung möglich ist. Über eine Steuerleitung 44 steht der Fourieranalyse-Prozessor 38 mit dem Steuer- und Abtastprozessor 33 in Verbindung.

Der Auswerteprozessor 29 umfaßt einen Klirrfaktorprozessor 45, der seinerseits Schaltungen zum Quadrieren, Addieren, Dividieren und Wurzelziehen sowie einen Kalibrierspeicher mit Kalibrierfaktoren für verschiedene Hallsonden 11 und Aufsetzjoche 6 enthält. Der Klirrfaktorprozessor 45 erhält direkt oder auf dem Umweg über einen Koeffizientenspeicher 46 als Eingangsgröße die komplexen Fourierkoeffizienten A1, A3, A5 und A7 über Eingangsleitungen 47 bis 50. Der Klirrfaktorprozessor 45 berechnet einen Klirrfaktor K als Meßgröße aus den Fourierkoeffizienten entsprechend folgender Formel

$$K = \sqrt{\frac{|A3|^2 + |A5|^2 + |A7|^2}{|A1|^2}}$$

Der so definierte Klirrfaktor ist eine Meßgröße, die kleiner als 1 ist und die, wie sich durch Versuche bestätigt hat, mit der maximalen induzierten Spannung in einer den Prüfkörper 10 umfassenden Spule eine sehr hohe Korrelation hat. Gegenüber den Verfahren aus der umfassenden Meßtechnik gestattet es jedoch die beschriebene Vorrichtung, in Aufsetztechnik die maximale induzierte Spannung, die ein Maß für die maximale Steigung der Hysteresekurve ist, bequem zu messen. Der Klirrfaktor K ist somit eine Meßgröße, die nach einer Multiplikation mit einem Kalibrierfaktor am Ausgang 51 einen Meßwert für die maximale Steigung der Hysteresekurve bzw. die differentielle Permeabilität am Koerzitivfeldstärkepunkt darstellt. Die maximale Steigung oder die maximale Steilheit der Hysteresekurve wird im Anzeigefeld 31 der Anzeigeeinheit 30 dargestellt. Neben der Auswertung der Proportionalität des Klirrfaktors gestattet es der in Fig. 2 dargestellte Auswerteprozessor 29 weiterhin in der nachfolgend beschriebenen Weise die Koerzitivfeldstärke aus dem zeitlichen Verlauf der Tangentialfeldstärke zu bestimmen.

Zu diesem Zweck wird unter Ausnutzung der komplexen Fourierkoeffizienten A3, A5 und A7 ein Oberwellensignal gebildet, das den Oberwellenanteil des Tangentialfeldstärkesignals ohne das Grundwellensignal darstellt. Bei der in Fig. 2 dargestellten Hardware-Lösung, die selbstverständlich auch als Software-Lösung auf einem Mehrzweckrechner realisiert sein kann, sind die Ausgänge des Koeffizientenspeichers 46 mit einer entsprechenden Zahl von Eingängen eines Fouriersynthese-. Prozessors 52 verbunden. Der Fouriersynthese-Prozessor 52 gestattet es, aus den komplexen Fourierkoeffizienten A3, A5 und A7 durch Superposition zu jedem Zeitpunkt das gesamte Oberwellensignal zu berechnen. Diese Fourierrücktransformation nach dem Herausfiltern der Grundfrequenz erfolgt unter der Steuerung des Steuerund Abtastprozessors 33, der mit dem Fouriersynthese-Prozessor 52 über eine Steuerleitung 53 verbunden ist.

Das vom Fouriersynthese-Prozessor 52 gelieferte Oberwellensignal stellt jeweils ein Zeitsignal mit der Dauer einer Periode des Grundsignals bzw. Tangentialfeldstärkesignals dar. Ein mit dem Ausgang des Fouriersynthese-Prozessors 52 verbundener Oberwellenspeicher 54 speichert eine Periode des Oberwellensignals, die in Fig. 3 als Oberwellenanteil der Tangentialfeldstärke dargestellt ist.

Der Steuer- und Abtastprozessor 33 ist über eine Adressen- und Steuerleitung 55 mit dem Oberwellenspeicher 54 verbunden, so daß die zu einem jeweiligen Abtastzeitpunkt gehörende Amplitude des Oberwellensignals vom Steuer- und Abtastprozessor 33 über eine Datenleitung 56 aus dem Oberwellenspeicher 54 ausgelesen werden kann. Der Steuer- und Abtastprozessor 33 ist über eine weitere Datenleitung 57 mit dem Ausgang 37 des Tangentialfeldstärkespeichers 54 verbunden, um durch eine Verknüpfung des zeitlichen Verlaufs der Tangentialfeldstärke und des Oberwellenanteils eine Meßgröße $H_{CO}$ aus der Abhängigkeit der Tangentialfeldstärke $H_t$ von der Zeit t abzuleiten. Die in der nachfolgenden Weise abgeleitete Meßgröße $H_{CO}$ ist ein Maß für die Koerzitivfeldstärke $H_{CBH}$, die üblicherweise in umfassender Technik aus der BH-Kurve ermittelt wird. Umfangreiche Versuche haben eine sehr hohe Korrelation zwischen der Meßgröße $H_{CO}$ und der Koerzitivfeldstärke $H_{CBH}$ ergeben.

Zur Ableitung der der Koerzitivfeldstärke zugeordneten Meßgröße $H_{CO}$ vergleicht der Steuer- und Abtastprozessor 33 den in Fig. 3 zum besseren Verständnis dargestellten Verlauf der Tangentialfeldstärke mit dem Verlauf des Oberwellenanteils. Dabei sucht der Steuer- und Abtastprozessor 33 den Zeitpunkt des ersten Nulldurchganges des Oberwellensignals oder des Oberwellenanteils nach einem Nulldurchgang des Tangentialfeldstärkesignals. Der absolute Tangentialfeldstärkewert bei der ersten Nullstelle des Oberwellensignals nach dem Nulldurchgang des Tangentialfeldstärkesignals (Remanenz) ist die oben mit $H_{CO}$ bezeichnete Meßgröße, die proportional der Koerzitivfeldstärke ist.

Die obigen Ausführungen zeigen, wie mit einer Oberwellenanalyse, die mit Hilfe der Fouriertransformation durchgeführt wurde, magnetische Kenngrößen bestimmt werden können. Erfahrungen haben gezeigt, daß die Entwicklung der Tangentialfeldstärke in eine Fourierreihe bis zur 7. Oberwelle ausreichend ist. Die aus den Fourierkoeffizienten ermittelten Amplituden der höheren Harmonischen liegen im Bereich der Meßgenauigkeit eines Analog/Digital-Umsetzers mit einer Auflösung von 10 Bit.

Dem Steuer- und Abtastprozessor 33 ist ein Koerzitivfeldstärkespeicher 58 zum Abspeichern der augenblicklichen Amplitude der Tangentialfeldstärke zum Zeitpunkt des ersten Nulldurchgangs des Oberwellensignals nach dem Nulldurchgang des Tangentialfeldstärkesignals zugeordnet. Der Koerzitivfeldstärkespeicher 58 ist daher unmittelbar mit dem Ausgang 37 des Tangentialfeldstärkespeichers 34 verbunden. Ausgangsseitig steht der Koerzitivfeldstärkespeicher 58 mit dem Anzeigefeld 32 der Anzeigeeinheit 30 in Verbindung.

Neben den bereits erwähnten Möglichkeiten der Messung der Koerzitivfeldstärke und der Bestimmung einer mit der maximalen Steigung der Hysterese korrelierenden Meßgröße gestattet es die oben beschriebene Vorrichtung sowie das erörterte Verfahren weiterhin Härteprofile zu bestimmen. Dazu ist es lediglich notwendig, die Messung der Meßgröße $H_{CO}$ bei unterschiedlichen Erregerfrequenzen durchzuführen. Durch eine Veränderung der Erregerfrequenz mit Hilfe der Frequenzeinstelleinrichtung 22 werden aufgrund der Wirbelstromdämpfung unterschiedliche Schichtdicken im Prüfkörper 10 analysiert. Der bei der Messung erfaßbare Tiefenbereich ist lediglich durch die Eindringtiefe des vom Aufsetzjoch 6 erzeugten Magnetfeldes beschränkt. Diese ist zum Beispiel bei 50 Hz nach der Standardeindringtiefeformel etwa 4,4 mm. Die Nutzung von Erregerfrequenzen im Bereich von mehr als 1 Hz ist besonders im Hinblick auf die industrielle Tauglichkeit des beschriebenen Verfahrens zur Materialprüfung von Interesse, da sie entsprechend kurze Meßzeiten und Prüftakte erlaubt. Obwohl die Fouriertransformation und die Berechnung des gesamten Oberwellensignals anhand einer Hardware-Realisierung beschrieben worden ist, liegt es auf der Hand, daß dies auch softwaremäßig erfolgen kann. Der Nulldurchgang im Tangentialfeldstärkefeld gibt bei einer Software-Lösung ebenfalls den zeitlichen Trigger zur Suche des darauffolgenden Nulldurchgangs im Oberwellensignal ein. Der zugehörige H-Feldwert im Tangentialfeldstärkesignal wird dann als $H_{CO}$ ausgelesen.

Es ist auch möglich, eine Abspaltung des Oberwellensignals aus dem Tangentialfeldstärkesignal in analoger Filtertechnik durchzuführen, was jedoch zu Phasenfehlern führt, die die phasenmäßige Auswertung bei der Nullstellensuche zur Bestimmung der Koerzitivfeldstärke erschweren. Die enstehenden Phasenfehler können zwar berücksichtigt werden, was aber im Hinblick auf eine möglichst variable Erregerfrequenz einen großen Aufwand darstellt, weshalb vorzugsweise statt einer analogen Filtertechnik entsprechend dem oben beschriebenen Ausführungsbeispiel Fourierprozessoren eingesetzt werden.

## Patentansprüche

1. Verfahren zum zerstörungsfreien Messen magnetischer Eigenschaften eines Prüfkörpers, der in Aufsetztechnik in einem Magnetfeld einer mit einem Wechselstrom gespeisten Erregerspule magnetisiert wird, indem die Hysteresekurve des Prüfkörpers mit der Frequenz des Wechselstroms mehrfach durchgesteuert wird und die durch die Erregerspule erzeugte Tangentialfeldstärke auf der Prüfkörperoberfläche mit Hilfe eines Magnetfeldstärkesensors während der Durchsteuerung der Hysteresekurve laufend erfaßt wird, wobei während der Durchsteuerung der Hysteresekurve ein Signal abgeleitet wird, dessen zeitlicher Verlauf dem zeitlichen Verlauf der Tangentialfeldstärke zugeordnet ist, **dadurch gekennzeichnet,** daß das abgeleitete Signal aus dem zeitlichen Verlauf des Tangentialfeldstärkesignals bestimmt wird, indem aus dem periodischen Gesamtsignal der Tangentialfeldstärke der Anteil des Oberwellensignals vom Gesamtwellensignal separiert wird, wobei die Separierung des Gesamtsignals durch eine Fourieranalyse einer Periode des Gesamtsignals erfolgt, mit deren Hilfe die komplexen Amplitudenkoeffizienten $A_i$ des Grundwellensignals und des Oberwellensignals bis mindestens zur Oberwelle 7. Ordnung bestimmt werden, daß als Maß für die Koerzitivfeldstärke des Prüfkörpers die augenblickliche Amplitude des Gesamtsignals der Tangentialfeldstärke zu einem Zeitpunkt ausgewählt wird, zu dem das mittels Fouriersynthese aus den obigen Amplitudenkoeffizienten Ai ermittelte Oberwellensignal der Tangentialfeldstärke nach einem Nulldurchgang des Gesamtsignals der Tangentialfeldstärke den ersten Nulldurchgang hat, und daß die Amplituden der im Gesamtsignal enthaltenen Oberwellen ins Verhältnis zur Amplitude der Grundwelle oder Gesamtwelle gemäß

$$K = \sqrt{\frac{|A3|^2 + |A5|^2 + |A7|^2 + \ldots}{|A1|^2}}$$

gesetzt wird, wobei der auf diese Weise ermittelte Klirrfaktor K ein Maß für die Steigung der Hysteresekurve bei der Koerzitivfeldstärke ist.

2. Verfahren nach Anspruch 1, dadurch gekennzeichnet, daß zur Bestimmung von Härtegradienten und damit auch der Einhärtetiefe die Frequenz des Speisestroms der Erregerspule zur Magnetisierung des Prüfkörpers durchgestimmt wird.

3. Vorrichtung zum zerstörungsfreien Messen magnetischer Eigenschaften eines Prüfkörpers mit einem auf den zu untersuchenden Prüfkörper mit seinen beiden Magnetpolen aufsetzbaren Aufsetzjoch, dessen Erregerspule zum Durchsteuern der Hysteresekurve des Prüfkörpers mit einer bipolaren Leistungsendstufe verbunden ist und zwischen dessen Magnetpolen ein Magnetfeldstärkesensor zur Erfassung der Tangentialfeldstärke angeordnet ist, der an einen Schaltkreis angeschlossen ist, welcher die durch Auswerten des zeitlichen Verlaufs der Tangentialfeldstärke bestimmten magnetischen Größen ausgibt, **dadurch gekennzeichnet,** daß der Magnetfeldstärkesensor (11) an einen Fourieranalyse-Prozessor (38) und an einen Fouriersynthese-Prozessor (52) angeschlossen ist, durch die der zeitliche Verlauf des periodischen Sensorsignals in seinen Grundwellenanteil und seinen Oberwellenanteil separierbar ist, wobei mit Hilfe des Fourieranalyse-Prozessors (38) das Sensorsignal bis mindestens zur Oberwelle 7. Ordnung in seine harmonischen Anteile zerlegbar ist und wobei mit Hilfe des Fouriersynthese-Prozessors (52) die durch den Fourieranalyse-Prozessor (38) separierten Oberwellenanteile zu einem von der Grundwelle befreiten Oberwellenanteil kombinierbar sind, und daß der Oberwellenanteil zusammen mit dem Gesamtsignal des Sensors (11) und/oder dem Grundwellenanteil eine Auswerteprozessoreinheit (29, 33, 45) speist, die einen Abtastprozessor (33) für den zeitlichen Verlauf des Gesamtsignals der Tangentialfeldstärke und des Oberwellenanteils der Tangentialfeldstärke umfaßt, durch den ein Selektionssignal für die Tangentialfeldstärke (57) erzeugbar ist, wenn dem gerade abgetasteten Gesamtsignal der Tangentialfeldstärke zeitlich ein Nulldurchgang des Oberwellenanteils zugeordnet ist, der als erster Nulldurchgang des Oberwellenanteils auf einen Nulldurchgang des Gesamtsignals folgt, daß der Auswerteprozessor (29) einen Klirrfaktorprozessor (45) umfaßt, durch den aus den Amplituden der Oberwellen $A_i$ und der Amplitude der Grundwelle $A_1$ der Klirrfaktor

$$K = \sqrt{\frac{|A3|^2 + |A5|^2 + |A7|^2 + \ldots}{|A1|^2}}$$

der Übertragungsstrecke zwischen der Erregerspule (5) und dem Magnetfeldstärkesensor (11) als Maß für die Steigung der Hysteresekurve bei der Koerzitivfeldstärke bestimmbar ist, wobei der Klirrfaktorprozessor (45) an den Ausgang (40 bis 43) des Fourieranalyse-Prozessors (38) angeschlossen ist.

4. Vorrichtung nach Anspruch 3, dadurch gekennzeichnet, daß durch den Fourieranalyse-Prozessor (38) und den Fouriersynthese-Prozessor (52) die Amplituden der Oberwellen der 3., 5. und 7.

Ordnung verarbeitbar sind.

**Claims**

1. A process for the non-destructive measurement of magnetic properties of a test object, which is magnetised in an application procedure in a magnetic field of an exciter coil supplied with an alternating current, in that the hysteresis curve of the test object is run through a plurality of times at the frequency of the alternating current and the tangential field strength generated by the exciter coil on the surface of the test object is continuously recorded by means of a magnetic field strength sensor while the hysteresis curve is being run through, wherein while the hysteresis curve is being run through a signal is derived whose configuration in respect of time is associated with the configuration in respect of time of the tangential field strength, characterised in that the derived signal is determined from the configuration in respect of time of the tangential field strength signal, in that out of the periodic overall signal of the tangential field strength the component of the harmonic signal is separated from the overall wave signal, wherein separation of the overall signal is effected by Fourier analysis of a period of the overall signal, by means of which the complex amplitude coefficients $A_i$ of the fundamental wave signal and the harmonic signal at least to the 7th-order harmonic are determined, that selected as the measurement in respect of the coercive field strength of the test object is the instantaneous amplitude of the overall signal of the tangential field strength at a time at which the harmonic signal of the tangential field strength, which is ascertained by means of Fourier synthesis from the foregoing amplitude coefficients $A_i$, after a passage through zero of the overall signal of the tangential field strength, has a first passage through zero, and that the amplitudes of the harmonics contained in the overall signal are related to the amplitude of the fundamental wave or the overall wave in accordance with:

$$K = \sqrt{\frac{|A3|^2 + |A5|^2 + |A7|^2 + \ldots}{|A1|^2}}$$

wherein the distortion factor K which is ascertained in that way is a measurement in respect of the gradient of the hysteresis curve at the coercive field strength.

2. A process according to claim 1 characterised in that the frequency of the supply current of the exciter coil for magnetisation of the test object is tuned for determining hardness gradients and therewith also the hardening depth.

3. Apparatus for the non-destructive measurement of magnetic properties of a test object comprising an application yoke which can be applied with its two magnetic poles to the test object to be investigated, the exciter coil of which yoke is connected to a bipolar power output stage for running through the hysteresis curve of the test body, while arranged between the magnetic poles of the yoke is a magnetic field strength sensor for detecting the tangential field strength, which is connected to a circuit which outputs the magnetic parameters which are determined by evaluation of the configuration in respect of time of the tangential field strength, characterised in that the magnetic field strength sensor (11) is connected to a Fourier analysis processor (38) and to a Fourier synthesis processor (52), by which the configuration in respect of time of the periodic sensor signal can be separated into its fundamental wave component and its harmonic component, wherein the sensor signal can be broken up into its harmonic components at least to the 7th-order harmonic by means of the Fourier analysis processor (38) and wherein the harmonic components which are separated by the Fourier analysis processor (38) can be combined by means of the Fourier synthesis processor (52) to provide a harmonic component which is free of the fundamental wave, and that the harmonic component together with the overall signal of the sensor (11) and/or the fundamental wave component supplies an evaluation processor unit (29, 33, 45) which includes a scanning processor (33) for the configuration in respect of time of the overall signal of the tangential field strength and the harmonic component of the tangential field strength, by which a selection signal for the tangential field strength (57) can be generated when associated in respect of time with the overall signal of the tangential field strength which is just being scanned is a passage through zero of the harmonic component, which as the first passage through zero of the harmonic component follows a passage through zero of the overall signal, that the evaluation processor (29) includes a distortion factor processor (45) for determining from the amplitudes of the harmonics $A_i$ and the amplitude of the fundamental wave $A_1$ the distortion factor

$$K = \sqrt{\frac{|A3|^2 + |A5|^2 + |A7|^2 + \dots}{|A1|^2}}$$

of the transmission path between the exciter coil (5) and the magnetic field strength sensor (11) as a measurement in respect of the gradient of the hysteresis curve at the coercive field strength, wherein the distortion factor processor (45) is connected to the output (40 to 43) of the Fourier analysis processor (38).

4. Apparatus according to claim 3 characterised in that the amplitudes of the harmonics of the 3rd, 5th and 7th orders can be processed by the Fourier analysis processor (38) and the Fourier synthesis processor (52).

## Revendications

1. Procédé de mesure sans destruction de caractéristiques magnétiques d'un échantillon, qui est aimanté selon la technique d'application, dans un champ magnétique d'une bobine excitatrice alimentée par un courant alternatif, par le fait que la courbe d'hystérésis de l'échantillon est commandée de façon multiple à la fréquence du courant alternatif et que l'intensité du champ tangentiel produit par la bobine excitatrice à la surface de l'échantillon est détectée en permanence au moyen d'un capteur de l'intensité du champ magnétique pendant le parcours de la courbe d'hystérésis, et selon lequel pendant la commande de la courbe d'hystérésis, on obtient un signal, dont la variation dans le temps est associée à la lecture dans le temps de l'intensité du champ tangentiel, caractérisé en ce que le signal obtenu est déterminé à partir de la variation dans le temps du signal de l'intensité du champ tangentiel, par le fait qu'à partir du signal périodique total de l'intensité du champ tangentiel, on sépare du signal de l'onde totale la composante du signal harmonique, la séparation du signal total étant réalisée au moyen d'une analyse de Fourier d'une période du signal total, à l'aide de laquelle les coefficients d'amplitude complexes $A_i$ du signal de l'onde fondamentale et du signal harmonique sont déterminés au moins jusqu'à l'harmonique du 7-ème ordre, qu'en tant que mesure de l'intensité du champ coercitif de l'échantillon, qu'on choisit l'amplitude instantanée du signal total de l'intensité du champ tangentiel à un instant auquel le signal harmonique, déterminé au moyen de l'analyse de Fourier à partir des coefficients d'amplitude $A_i$ précités de l'intensité du champ tangentiel présente le premier passage par zéro après un passage par zéro du signal total de l'intensité du champ tangentiel, et que les amplitudes des harmoniques contenus dans le signal total sont rapportées à l'amplitude de l'onde fondamentale ou de l'onde totale conformément à

$$K = \sqrt{\frac{|A3|^2 + |A5|^2 + |A7|^2 + \dots}{|A1|^2}}$$

le facteur de distorsion harmonique K déterminé de cette manière étant une mesure de la pente de la courbe d'hystérésis pour l'intensité du champ coercitif.

2. Procédé selon la revendication 1, caractérisé en ce que pour la détermination du gradient de trempe et par conséquent également de la profondeur de trempe, on détermine la fréquence du courant d'alimentation de la bobine excitatrice pour l'aimantation de l'échantillon.

3. Dispositif pour mesurer sans destruction des caractéristiques magnétiques d'un échantillon au moyen d'une culasse d'application, qui peut être appliquée par ses pôles magnétiques sur l'échantillon à examiner et dont la bobine excitatrice est raccordée, pour la commande de la courbe d'hystérésis de l'échantillon, à un étage final bipolaire de puissance et entre les pôles magnétiques de laquelle est disposé un capteur de l'intensité du champ magnétique servant à détecter l'intensité du champ tangentiel et qui est raccordé à un circuit qui indique la grandeur magnétique déterminée par évaluation de la variation dans le temps de l'intensité du champ tangentiel, caractérisé en ce que le capteur (11) de l'intensité du champ magnétique est raccordé à un processeur d'analyse de Fourier (38) et un processeur de synthèse de Fourier (52), au moyen desquels la composante de l'onde fondamentale et la composante de l'onde harmonique de la variation dans le temps du signal périodique du capteur peuvent être séparées, auquel cas le signal du capteur peut être subdivisé à l'aide du processeur d'analyse de Fourier (38), au moins jusqu'à l'harmonique du 7-ème ordre, en ses composantes harmoniques, et les composantes d'ondes harmoniques séparées par le processeur d'analyse de Fourier (38) peuvent être combinées, au moyen du processeur de synthèse de Fourier (52), pour former une composante harmonique dont est supprimée l'onde fondamentale, et que la composante harmonique ainsi que le signal total du capteur (11) et/ou la composante d'onde fondamentale alimentent une unité formant processeur d'évaluation (29,33,45), qui comprend un processeur d'échantillonnage (33) pour la variation dans le temps du signal total de l'intensité du champ tangentiel et de la composante harmonique de l'intensité du champ tangentiel et au moyen duquel un signal de sélection pour l'intensité (57) du champ tangentiel peut être produit lorsqu'au signal total précisément échantillonné de l'intensité du champ tangentiel est associée, dans le temps, un passage par zéro de la composante harmonique, qui succède, en tant que premier passage par zéro de la composante harmonique, à un passage par zéro du signal total, que le processeur d'évaluation (29) contient un processeur (45) de traitement du facteur de distorsion harmonique, qui, à partir des amplitudes des harmoniques $A_i$ et de l'amplitude de l'onde fondamentale $A_1$, détermine le facteur de distorsion harmonique

$$K = d\sqrt{\frac{|A3|^2 + |A5|^2 + |A7|^2 + \dots}{|A1|^2}}$$

de la section de transmission entre la bobine excitatrice (5) et le capteur (11) de l'intensité du champ magnétique en tant que mesure de la pente de la courbe d'hystérésis pour l'intensité du champ coercitif, le processeur (45) de traitement du facteur de distorsion harmonique étant raccordé à la sortie (40 à 43) du processeur d'analyse de Fourier (38).

4. Dispositif selon la revendication 3, caractérisé en ce que les amplitudes des harmoniques des 3-ème, 5-ème et 7-ème ordres peuvent être traitées par le processeur d'analyse de Fourier (38) et par le processeur de synthèse de Fourier (52).

Fig. 1

EP 0 365 622 B1

Fig. 2

EP 0 365 622 B1

Fig. 3

EP 0 365 622 B1